(19) **Europäisches Patentamt European Patent Office Office européen des brevets**

(11) **EP 2 530 839 A1**

(12) **EUROPEAN PATENT APPLICATION**
published in accordance with Art. 153(4) EPC

(43) Date of publication:
**05.12.2012 Bulletin 2012/49**

(51) Int Cl.:
**H03H 17/00** *(2006.01)*    **H03H 17/02** *(2006.01)*

(21) Application number: **11734716.1**

(22) Date of filing: **20.01.2011**

(86) International application number:
**PCT/JP2011/050964**

(87) International publication number:
**WO 2011/090110 (28.07.2011 Gazette 2011/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.01.2010 JP 2010013423**

(71) Applicant: **Mitsubishi Electric Corporation Tokyo 100-8310 (JP)**

(72) Inventors:
• **TOMITSUKA, Koji**
  **Tokyo 100-8310Tokyo 100 - 8310 (JP)**
• **SANO, Hiroyasu**
  **Tokyo 100-8310 (JP)**

(74) Representative: **Pfenning, Meinig & Partner GbR Patent- und Rechtsanwälte Theresienhöhe 13 80339 München (DE)**

(54) **SAMPLING RATE CONVERSION DEVICE, AND SAMPLING RATE CONVERSION METHOD**

(57)    A sampling rate converting apparatus that performs sampling frequency conversion includes: a sampling-phase detecting unit (1) configured to calculate a sampling phase based on sampling timing after the sampling frequency conversion for each operation reference clock, based on a ratio of a frequency of an operation reference clock and a sampling frequency after the sampling frequency conversion; a sampling-clock detecting unit (2) configured to detect a sampling period based on the sampling phase; a poliphase filter (3) configured to apply filtering to an input signal and generate a signal after the sampling frequency conversion, based on the sampling period; and a filter-coefficient control unit (4) configured to set a filter coefficient in the poliphase filter (3), based on the sampling phase.

## FIG.1

EP 2 530 839 A1

**Description**

TECHNICAL FIELD

The present invention relates to a sampling rate converting apparatus and a sampling rate converting method for converting a sampling rate of a digital signal waveform into a different sampling rate.

BACKGROUND ART

In a related art, sampling rate conversion for a digital signal can be realized by processing interpolation (oversampling) and decimation of the signal in combination. When an original sampling rate before conversion is converted into a sampling rate N/M (N and M are positive integers) times as large as the original sampling rate, after the signal is oversampled to an N-times sampling rate by the interpolation, every M samples are extracted (subsampled) from the interpolated signal. However, when the signal is oversampled, it is necessary to perform filtering using an interpolation filter having frequency characteristics for preventing an alias from occurring when the signal is converted into the N/M-times sampling rate.

When the signal is interpolated to be oversampled to the N-times sampling rate, a filter operation is performed for each position to be interpolated using a poliphase filter. This makes it possible to reduce an unnecessary filter operation and realize interpolation processing with a small amount of operations (circuit size).

It is possible to carry out sampling rate conversion to an arbitrary sampling rate by adjusting N and M using the N/M-times sampling rate conversion explained above (see, for example, Non Patent Literature 1).

Citation List

Non Patent Literature

Non Patent Literature 1: Yoshikazu Nishimura, Communication System Design by Digital Signal Processing, CQ Publishing Co., Ltd., p. 85 to 89

DISCLOSURE OF INVENTION

PROBLEM TO BE SOLVED BY THE INVENTION

However, according to the technology described in Non Patent Literature 1, after an interpolation filter coefficient is switched at equal interval times using the poliphase filter to perform the interpolation processing of the N-times oversampling, every M samples are extracted from the interpolated N-times signal, whereby a signal converted into the N/M-times (N and M are positive integers) sampling rate is obtained. Therefore, there is a problem in that, when values of N and M increase, a filter coefficient and the number of filter stages necessary for interpolation increase and an amount of operations (circuit size) of the poliphase filter increases.

When it is attempted to realize a function of adjusting a sampling rate to an arbitrary sampling rate using the method of the related art without using the poliphase filter, it is necessary to prepare coefficients of all interpolation filters corresponding to the N/M-times sampling rate conversion. Therefore, when a circuit size is taken into account, it is difficult to realize a sampling rate variable apparatus in a wide range and at high resolution (e.g., resolution equal to or lower than 1Hz unit). Therefore, there is a problem in that a circuit size allowed in the apparatus and a variable range of a sampling rate are in a tradeoff relation.

The present invention has been devised in view of the above and it is an object of the present invention to obtain a sampling rate converting apparatus and a sampling rate converting method that can make, with a small circuit size, a sampling rate after sampling rate conversion of a digital signal variable.

MEANS FOR SOLVING PROBLEM

To solve the problem and to achieve the above object, there is provided a sampling rate converting apparatus that performs sampling frequency conversion to an input signal sampled at a predetermined sampling period with using an operation reference clock having a predetermined clock frequency, the sampling rate converting apparatus comprising: a sampling-phase detecting unit configured to calculate a sampling phase based on sampling timing after the sampling frequency conversion for each the operation reference clock, based on a ratio between the clock frequency and a sampling frequency after the sampling frequency conversion; a sampling-clock detecting unit configured to detect a sampling period after the sampling frequency conversion, based on the sampling phase; a filter unit configured to apply filtering to the input signal and to generate a post-conversion signal based on a signal after the filtering and the sampling period, the post-conversion signal being a signal after the sampling frequency conversion; and a filter control unit configured to set a filter coefficient used for the filtering, based on the sampling phase.

EFFECT OF THE INVENTION

In the sampling rate converting apparatus and the sampling rate converting method according to the present invention, a phase of a clock of an output sampling rate after sampling rate conversion is calculated, a phase error from a sampling point after the sampling rate conversion and a sampling clock are calculated based on the calculated phase, and a filter coefficient of a poliphase filter is adaptively controlled and a sampling rate is converted based on the phase error and the sampling clock. Therefore, there is an effect that it is possible to make, with a small circuit size, a sampling rate after sampling rate conversion of a digital signal variable.

BRIEF DESCRIPTION OF DRAWINGS

FIG. 1 is a diagram of a functional configuration example of a sampling rate converting apparatus according to a first embodiment.
FIG. 2 is a diagram of a configuration example of a sampling-phase detecting unit.
FIG. 3 is a diagram for explaining the operations of the sampling-phase detecting unit and a sampling-clock detecting unit.
FIG. 4 is a diagram of a configuration example of a poliphase filter.
FIG. 5 is a diagram of another configuration example of the poliphase filter.
FIG. 6 is a diagram of a functional configuration example of a sampling rate converting apparatus according to a second embodiment.
FIG. 7 is a diagram of a configuration example of a sampling-phase detecting unit according to the second embodiment.
FIG. 8 is a diagram of another configuration example of the sampling-phase detecting unit according to the second embodiment.

EMBODIMENT(S) FOR CARRYING OUT THE INVENTION

Embodiments of a sampling rate converting apparatus and a sampling rate converting method according to the present invention are explained in detail below based on the drawings. The present invention is not limited by the embodiments.

First Embodiment.

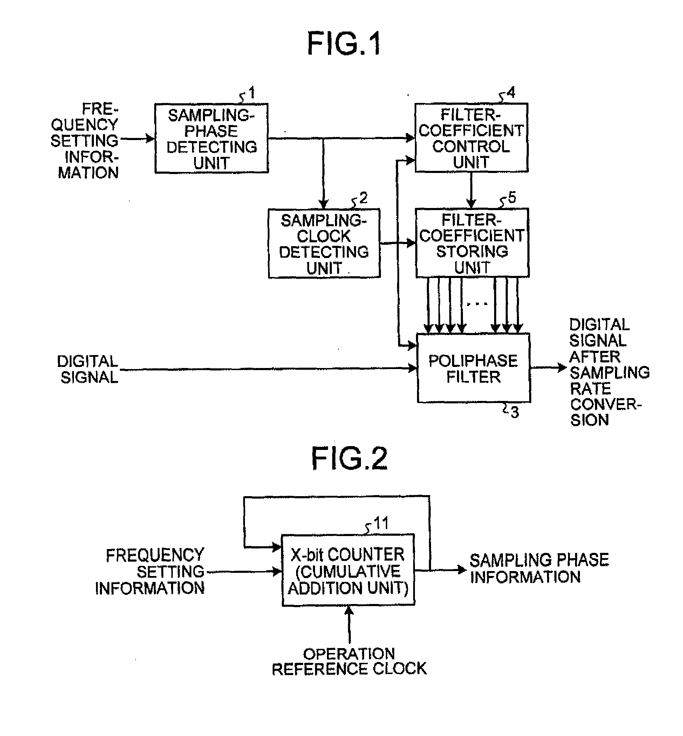

FIG. 1 is a diagram of a functional configuration example of a first embodiment of the sampling rate converting apparatus according to the present invention. As shown in FIG. 1, the sampling rate converting apparatus according to this embodiment includes a sampling-phase detecting unit 1 that detects, based on frequency setting information representing a ratio of an original sampling rate of a digital signal, which is an input signal, and a sampling rate after sampling rate conversion, a phase (sampling phase information) of the sampling rate after the conversion, a sampling-clock detecting (generating) unit 2 that detects, based on the sampling phase information, a post-conversion sampling period and generates a sampling clock, a poliphase filter 3 that interpolates the input signal to be oversampled to N times and simultaneously performs extraction at a conversion-target sampling rate, a filter-coefficient control unit 4 that instructs a filter coefficient to be set in the poliphase filter 3, and a filter-coefficient storing unit 5 that stores the filter coefficient to be used in the poliphase filter 3 and that reads out, based on the instruction of the filter-coefficient control unit 4, the filter coefficient and set the filter coefficient in the poliphase filter 3.

FIG. 2 is a diagram of a configuration example of the sampling-phase detecting unit 1. The sampling-phase detecting unit 1 includes an X-bit counter (a cumulative addition unit) 11, which is an X-bit width counter (a counter from 0 to $2^x$),

Frequency setting information set in (input to) the sampling rate converting apparatus according to this embodiment is a value indicating a ratio between an original sampling rate of a digital signal, which is an input signal, and a sampling rate after sampling rate conversion. The frequency setting information is calculated based on Formula (1) below, for example, when the input signal is a digital signal sampled by P-times oversampling and the input signal is down-sampled to a Q (Q is a real number equal to or smaller than P)-times oversampling signal.

$$\text{Frequency setting information} = P/Q \times 2^x \quad (1)$$

X is a parameter related to resolution for interpolating the input signal and is equivalent to the bit width X of the X-bit counter 11 of the sampling-phase detecting unit 1. Q is the real number equal to or smaller than P. X is a numerical value for determining phase resolution of a Q-times oversampling signal. A sampling phase at phase resolution of $1/2^x$ of the Q-times oversampling signal can be detected.

The X-bit counter 11 of the sampling-phase detecting unit 1 performs cumulative addition of frequency setting information at an operation reference clock interval and calculates, according to Formula (2) below, sampling phase information $\theta(k)$ indicating a sampling phase of the Q-times oversampling signal (the input signal) (a phase of a sine wave having a sampling period of the Q-times oversampling signal, i.e., a phase of a sampling clock). In Formula (2), k is an integer equal to or larger than 0 and corresponds to time discretized in a unit of an operation reference clock.

$$\theta(k) = \theta(k-1) + (\text{frequency setting information}) \quad (2)$$

As indicated by Formula (2), the sampling phase information is a result obtained by the X-bit counter 11 cumulatively-adding the frequency setting information. When a value calculated by Formula (2) exceeds a maximum $2^x$, the X-bit counter 11 subtracts the maximum $2^x$ from the calculated value and calculates a value in a range of 0 to $2^x$.

Although the operation reference clock is a clock set as a reference for the operation of the sampling rate converting apparatus according to this embodiment, for simplification, this embodiment exemplifies the case where the frequency of the operation reference clock is set the same as a sampling frequency of P-times oversampling. If the frequency of the operation reference clock is different from the sampling frequency of the P-time oversampling, when the frequency of the operation reference clock is represented as A and the sampling frequency of the Q-times oversampling is represented as B, $A/B \times 2^x$ can be used as the frequency setting information.

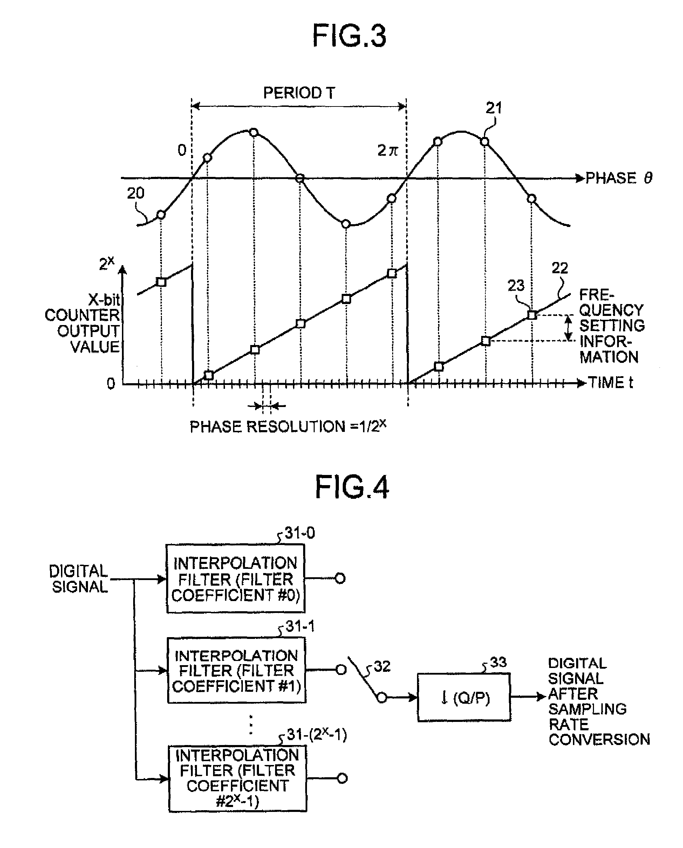

A principle in which the X-bit counter 11 can detect a sampling phase of a Q-times oversampling signal by calculating $\theta(k)$ according to the method explained above is explained. FIG. 3 is a diagram for explaining the operations of the sampling-phase detecting unit 1 and the sampling-clock detecting unit 2. The sampling phase detection principle for the Q-times oversampling signal is explained with reference to FIG. 3.

A sampling period (a post-conversion sampling period) obtained when a sampling rate of the input signal is converted to convert the input signal into the Q-times oversampling signal is represented as T. A sine wave waveform 20 is a waveform of a sine wave having the period T. Operation reference clock sampling points 21 (white circles on the sine wave waveform 20 in FIG. 3) indicate sampling points of sampling of the sine wave waveform 20 performed at every operation reference clock.

In this embodiment, sampling phases (0 to $2\pi$) for one period of the input signal are associated with a range of counter values (0 to $2^x$) of the X-bit counter 11 and are represented by counter values. Specifically, the sampling phase 0 is associated with the counter value 0 and the sampling phase $2\pi$ is associated with the counter value $2^x$. Therefore, the input signal has phase resolution of $1/2^x$ with respect to the range of the sampling phases 0 to $2\pi$.

A counter value 22 indicates values obtained by converting the phase of the sine wave waveform 20 into the counter values of 0 to $2^x$. Sampling phase information 23 (white squares on the counter value 22) is an output value of the X-bit counter 11 calculated by Formula (2) and indicates sampling phase information $\theta(k)$.

The frequency setting information represents a phase shift amount per one operation reference clock. Therefore, the X-bit counter 11 cumulatively-adds the frequency setting information to the for each operation reference clock to thereby calculate a value obtained by quantizing a sampling phase at time k of the input signal at the phase resolution of $1/2^x$. The X-bit counter 11 can detect a sampling phase at time k of the Q-times oversampling signal. Sampling points of the Q-times oversampling signal are sampled at the sampling period T. Therefore, when a sampling point is a point of a sampling phase 0, the sampling phase information indicates a phase difference from the sampling point of the Q-times oversampling signal, i.e., a phase error from a Nyquist point at the sampling rate of the Q-times oversampling.

The sampling-clock detecting unit 2 performs detection of a sampling clock of the Q-times oversampling using the sampling phase information detected by the sampling-phase detecting unit. The sampling clock is a signal having the period T shown in FIG. 3. A point where the phase of the sine wave waveform 20 at the period T is $0(2\pi)$ is set as a sampling point and a sampling clock is generated. However, this is not a limitation. A phase position (e.g., $\pi$) other than 0 can be set as a sampling point as long as a sampling clock having the period T can be generated.

Specifically, the sampling-clock detecting unit 2 observes the sampling phase information output from the X-bit counter 11, detects a change point where the sampling phase information exceeds $2^x$ and returns to 0, and generates a sampling clock at each period of the change point.

The filter-coefficient control unit 4 selects, based on the sampling phase information output from the sampling-phase detecting unit 1, i.e., a phase error from the Nyquist point (a sampling point in sampling at a Nyquist frequency) at the sampling rate of the Q-times oversampling at time k, an interpolation filter coefficient set in the poliphase filter 3, and the filter-coefficient control unit 4 instructs the filter-coefficient storing unit 5 to set the interpolation filter coefficient in the poliphase filter 3. The filter-coefficient control unit 4 performs the processing explained above at every sampling clock (signal at each period of the sampling clock) output from the sampling-clock detecting unit 2. The filter-coefficient control unit 4 uses, as a phase error, sampling phase information output earliest after a point in time when the sampling clock is received (a point of the sampling phase 0). It is assumed that the frequency of the operation reference clock is equivalent to the sampling frequency of the P-times oversampling.

The sampling phase information output from the sampling-phase detecting unit 1 represents a phase error from the Nyquist point (sampling timing) based on the sampling period of the Q-times oversampling. The poliphase filter 3 applies interpolation to the digital signal of the P-times oversampling, which is the input signal, and corrects the phase error. Therefore, to select the interpolation filter coefficient, it is necessary to calculate the interpolation filter coefficient using a phase error from the sampling timing of the P-times oversampling (a phase error caused when the sampling frequency of the P-times oversampling is set to $2\pi$).

When the frequency of the operation reference clock is equivalent to the sampling frequency of the P-times oversampling, a phase error of Q times standard indicates, as a phase error caused when the sampling frequency of the Q-times oversampling is set to $2\pi$, a difference between the sampling timing of the P-times oversampling and the sampling timing of the Q-times oversampling, i.e., a position to be interpolated based on the sampling timing of the P-times oversampling. In this embodiment, an interpolation position in the poliphase filter 3 is associated with the phase error (resolution of $1/2^x$) obtained when the sampling period of the P-times oversampling is set to $2\pi$. The filter-coefficient storing unit 5 stores an interpolation filter coefficient for each phase error corresponding to the sampling frequency of the P-times oversampling. Therefore, to select the interpolation filter coefficient, it is necessary to convert the phase error based on the sampling period of the Q-times oversampling into a phase error based on the P-times oversampling.

Specifically, for example, as indicated by Formula (3) below, the sampling phase information (the phase error of Q times standard: the phase error based on the sampling frequency of the Q-times oversampling) is converted into a phase error based on the sampling frequency of the P-times oversampling (a phase error of P times standard).

$$(\text{Phase error of P times standard}) = (\text{phase error of Q times standard}) \times P/Q \qquad (3)$$

The filter-coefficient control unit 4 selects, out of interpolation filter coefficients stored by the filter-coefficient storing unit 5, an interpolation filter coefficient with which the Nyquist point (sampling timing) at the sampling rate of the Q-times oversampling can be extracted, based on the phase error of P times standard. The filter-coefficient control unit 4 instructs the filter-coefficient storing unit 5 to set the selected interpolation filter coefficient in the poliphase filter 3. It is necessary to store $2^x$ (#0 to #$2^x$-1) interpolation filter coefficients in the filter-coefficient storing unit 5 to correspond to the resolution (the resolution of $1/2^x$) of the phase error of P times standard. A method of calculating the interpolation filter coefficient is not specifically limited. The interpolation filter coefficient can be calculated by a method similar to the method of the related art.

If the frequency of the operation reference clock is not equivalent to the sampling frequency of the P-times oversampling, when the phase error of P times standard is calculated, in addition to Formula (3), it is necessary to take into account a phase error (an input signal phase error) caused by a difference between the operation reference clock and the sampling timing of the P-times oversampling. For example, when the frequency of the operation reference clock is represented as A, the sampling frequency of the P-times oversampling is represented as C, and $C/B \times 2^x$ represents frequency setting information for P times, the frequency setting information for P times can be calculated as a value subjected to cumulative addition in the same manner as Formula (2). The phase error of P times standard can be calculated based on the right side of Formula (3) and the input signal phase error.

The filter-coefficient storing unit 5 sets, based on the instruction from the sampling-coefficient control unit 4, the interpolation filter coefficient in the poliphase filter 3. The poliphase filter 3 applies filtering processing and sub-sampling processing into the Q-times sampling rate to the input signal using the set interpolation filter coefficient and outputs a digital signal converted into the sampling rate of the Q-times oversampling.

FIG. 4 is a diagram showing a configuration example of the poliphase filter 3. In the configuration example shown in FIG. 4, the poliphase filter 3 includes interpolation filters 31-0 to 31-($2^x$-1) respectively corresponding to different interpolation filter coefficients (filter coefficients #0 to #$2^x$-1) (corresponding to signals at different phase timings), a switching unit 32, and a Q/P resampler 33. $2^x$ corresponding to the phase $2\pi$ is similar to that corresponding to the phase 0. Therefore, the number of interpolation filter coefficients is $2^x$ from #0 to #$2^x$-1. The filter coefficients #1 to #$2^x$-1 respectively corresponding to the interpolation filters 31-0 to 31-($2^x$-1) are set in advance for the interpolation filters 31-0 to 31-($2^x$-1). In this case, when the filter-coefficient storing unit 5 sets the interpolation filter coefficient in the poliphase filter 3, the filter-coefficient storing unit 5 can instruct the interpolation filters 31-0 to 31-($2^x$-1) used for the processing. The switching unit 32 inputs, to the Q/P resampler 33, outputs from the instructed interpolation filters 31-0 to 31-($2^x$-1).

The Q/P resampler 33 resamples, based on the sampling clock detected by the sampling-clock detecting unit 2, signals output from the interpolation filters 31-0 to 31-($2^x$-1) such that the signals are output at a period interval of the sampling clock.

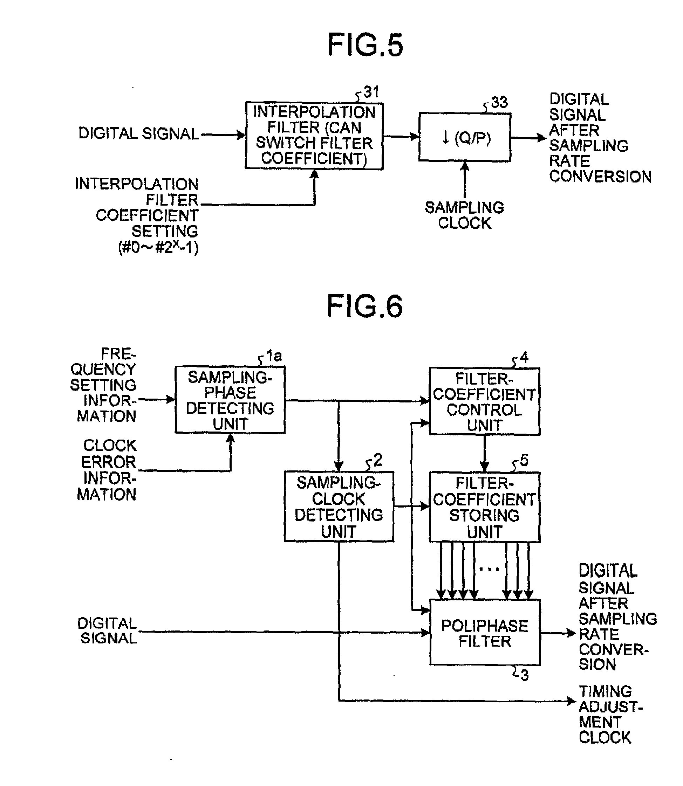

FIG. 5 is a diagram of another configuration example of the poliphase filter 3. In the example shown in FIG. 5, the poliphase filter 3 includes an interpolation filter 31 that can switch interpolation coefficient filters, and the Q/P resampler 33. The function of the Q/P resampler 33 is similar to that in the configuration example shown in FIG. 4. In the configuration example shown in FIG. 5, a circuit size can be reduced compared with the configuration example shown in FIG. 4. The configuration of the poliphase filter 3 is not limited to the configuration examples shown in FIGS. 4 and 5 and can be any configuration as long as the same function is realized.

The following explanation is based on the configuration example shown in FIG. 5. In the configuration example shown in FIG. 5, in the poliphase filter 3, the filter-coefficient storing unit 5 instructs the poliphase filter 3 to set an interpolation filter coefficient. The interpolation filter 31 sets the instructed interpolation filter coefficient. As explained above, the interpolation filter coefficient is instructed at the sampling clock period.

The filter-coefficient storing unit 5 and the poliphase filter 3 are provided as separate components. However, the filter-coefficient storing unit 5 and the poliphase filter 3 can be considered one filter unit. In this case, the filter-coefficient control unit 4 instructs the filter unit to set information (a phase error of P times standard) for selecting an interpolation filter coefficient.

In the example explained in this embodiment, the down-sampling is performed. However, the operation in this embodiment can be applied when up-sampling (Q>P) is performed.

As explained above, in this embodiment, a phase of an output sampling rate (Q-times oversampling) clock after sampling rate conversion is calculated in an operation reference clock unit using the X-bit counter 11 having the X-bit phase resolution. A phase error from the Nyquist point and a sampling clock are calculated based on the calculated phase. A sampling rate is converted by adaptively controlling the filter coefficient of the poliphase filter and interpolating a signal, based on the phase error and the sampling clock. Therefore, it is possible to realize the sampling rate conversion at an arbitrary ratio by changing frequency setting information (parameters concerning P and Q).

In this embodiment, the filter coefficient for interpolating a signal is adaptively controlled. Therefore, simply by providing an interpolation filter coefficient having necessary frequency resolution for adjustment accuracy of a sampling rate of a digital signal, it is possible to realize a sampling rate variable function which makes a sampling rate after sampling conversion variable. Therefore, it is possible to substantially reduce a memory capacity (circuit size) for storing filter coefficients for signal interpolation, which are necessary in a large amount in the related art to make a sampling conversion ratio variable.

Second Embodiment.

FIG. 6 is a diagram of a functional configuration example in a second embodiment of the sampling rate converting apparatus according to the present invention. The sampling rate converting apparatus according to this embodiment is similar to the sampling rate converting apparatus according to the first embodiment except that the sampling-phase detecting unit 1 of the sampling rate converting apparatus according to the first embodiment is replaced with a sampling-phase detecting unit 1a. Components having functions similar to those in the first embodiment are denoted by reference numerals and signs same as those in the first embodiment and explanation of the components is omitted.

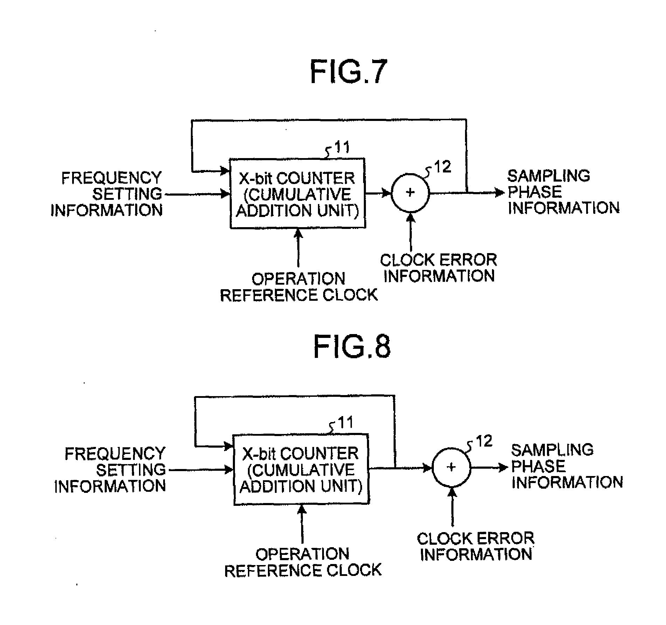

FIG. 7 is a diagram of a configuration example of the sampling-phase detecting unit 1a. As shown in FIG. 7, the sampling-phase detecting unit 1a includes the X-bit counter 11 and an adder 12. In the sampling-phase detecting unit 1a in this embodiment further includes a function for adjusting timing of a sampling clock, in addition to the function of the sampling-phase detecting unit 1 in the first embodiment.

The adder 12 adds clock error information corresponding to a timing error of an operation reference clock, to sampling phase information output from the X-bit counter 11. The operation of the X-bit counter 11 is similar to the operation of the X-bit counter 11 in the first embodiment. However, in this embodiment, in cumulative addition, the X-bit counter 11 adds frequency setting information to an output of the adder 12. By adopting such a configuration, it is possible to perform adjustment of sampling timing at resolution of $1/2^x$. In this configuration, when the timing adjustment is performed once, after the clock error information is input to the adder 12 once, the clock error information is reset to 0.

FIG. 8 is a diagram of another configuration example of the sampling-phase detecting unit 1a. In the configuration shown in FIG. 8, the operation of the X-bit counter 11 is similar to the operation of the X-bit counter 11 in the first embodiment. The adder 12 adds clock error information to sampling phase information after cumulative addition similar to that in the first embodiment. In the case of this configuration, as the clock error information, the same value is used while a clock error is adjusted with the same value. In both the configuration examples shown in FIGS. 7 and 8, both positive and negative values can be input as the clock error information. The clock error information can be set from the outside. Alternatively, the sampling-phase detecting unit 1a can include a calculation function for calculating an error of a clock and can use clock error information calculated by the calculation function.

By adopting the configuration shown in FIG. 8, for example, it is also possible to arbitrarily set an initial value of a sampling phase. As a specific example, when +256 is set as clock error information with respect to a 10-bit counter value (in a range of 0 to 1024) in the case of X=10, sampling timing can be advanced by a 1/4 (=256/1024) sampling clock period. When -256 is set as the clock error information, conversely, the sampling timing can be delayed by the 1/4 sampling clock period. Operations in this embodiment other than the operations explained above are the same as those in the first embodiment.

As explained above, in this embodiment, because the sampling-phase detecting unit 1a adjusts the sampling timing and the sampling-clock detecting unit 2 detects a sampling clock based on sampling phase information after the adjustment, it is possible to obtain a sampling clock reflecting the timing adjustment. Therefore, it is possible to obtain effects similar to those in the first embodiment, and is also possible to adjust a phase of the sampling clock at resolution of $1/2^x$, and to reduce the influence of an error of an oscillator that generates an operation reference clock and to improve accuracy of the sampling clock.

INDUSTRIAL APPLICABILITY

As explained above, the sampling rate converting apparatus and the sampling rate converting method according to the present invention are useful for a sampling rate converting apparatus that converts a sampling rate of a digital signal waveform into a different sampling rate and, in particular, suitable for a sampling rate converting apparatus that makes the sampling rate after the conversion variable.

EXPLANATIONS OF LETTERS OR NUMERALS

| | |
|---|---|
| 1 | sampling-phase detecting unit |
| 2 | sampling-clock detecting unit |
| 3 | poliphase filter |
| 4 | filter-coefficient control unit |
| 5 | filter-coefficient storing unit |
| 11 | X-bit counter |
| 12 | adder |
| 31, 31-0 to 31-($2^x$-1) | interpolation filters |
| 32 | switching unit |
| 33 | Q/P resampler |
| 20 | sine wave waveform |
| 21 | operation reference clock sampling points |
| 22 | counter value |
| 23 | sampling phase information |

**Claims**

1. A sampling rate converting apparatus that performs sampling frequency conversion to an input signal sampled at a predetermined sampling period with using an operation reference clock having a predetermined clock frequency, the sampling rate converting apparatus comprising:

   a sampling-phase detecting unit configured to calculate a sampling phase based on sampling timing after the sampling frequency conversion for each the operation reference clock, based on a ratio between the clock frequency and a sampling frequency after the sampling frequency conversion;
   a sampling-clock detecting unit configured to detect a sampling period after the sampling frequency conversion, based on the sampling phase;
   a filter unit configured to apply filtering to the input signal and to generate a post-conversion signal based on a signal after the filtering and the sampling period, the post-conversion signal being a signal after the sampling frequency conversion; and

a filter control unit configured to set a filter coefficient used for the filtering, based on the sampling phase.

2. The sampling rate converting apparatus according to claim 1, wherein
the sampling-phase detecting unit includes a counter, the counter having N (N is an integer equal to or larger than 1)-bit width, the counter cumulatively-adding frequency setting information determined based on a ratio of the clock frequency and the sampling frequency after the sampling frequency conversion to cumulative addition, the counter setting a value obtained by subtracting $2^N$ from a result of the cumulative addition as a cumulative addition result when the result of the cumulative addition exceeds $2^N$, and the counter setting the result of the cumulative addition as the sampling phase when the result of the cumulative addition is equal to or smaller than $2^N$.

3. The sampling rate converting apparatus according to claim 2, wherein
the sampling-phase detecting unit adds a predetermined value for adjusting the sampling phase to the result of the cumulative addition.

4. The sampling rate converting apparatus according to claim 3, wherein
the predetermined value is set based on a clock error of the operation reference clock.

5. The sampling rate converting apparatus according to any one of claims 2 to 4, wherein
the filter control unit stores $2^N$ sets of filter coefficients used in the filtering corresponding to $2^N$ phase points into which the sampling period of the input signal is discretized, selects a filter coefficient from the $2^N$ sets of filter coefficients based on the sampling phase, and sets the selected filter coefficient as a filter coefficient used for the filtering.

6. The sampling rate converting apparatus according to any one of claims 2 to 4, wherein
the filter unit includes $2^N$ filters,
the filter unit sets, in the fillers, $2^N$ sets of filter coefficients used in the filtering corresponding to $2^N$ phase points into which the sampling period of the input signal is discretized, such that the filter and one set of the filter coefficients correspond to each other in a one to one relation, and
the filter control unit selects the filter used for the filtering based on the sampling phase to thereby set a filter coefficient used for the filtering.

7. The sampling rate converting apparatus according to any one of claims 1 to 6, wherein
the sampling-clock detecting unit generates a sample clock indicating sampling timing after the sampling frequency conversion, based on the sampling period.

8. The sampling rate converting apparatus according to claim 7, wherein
the filter unit performs resampling to the signal subjected to the filtering based on the sample clock, and sets a signal after the resampling as the post-conversion signal.

9. The sampling rate converting apparatus according to any one of claims 1 to 8, wherein
the predetermined clock frequency is set as a sampling frequency of the input signal.

10. A sampling rate converting method in a sampling rate converting apparatus that performs sampling frequency conversion to an input signal sampled at a predetermined sampling period with using an operation reference clock having a predetermined clock frequency, the sampling rate converting method comprising:

a sampling-phase detecting step of calculating a sampling phase based on sampling timing after the sampling frequency conversion for each the operation reference clock, based on a ratio between the clock frequency and a sampling frequency after the sampling frequency conversion;
a sampling-clock detecting step of detecting a sampling period after the sampling frequency conversion, based on the sampling phase;
a filtering step of applying filtering to the input signal and generating a post-conversion signal based on a signal after the filtering and the sampling period, the post-conversion signal being a signal after the sampling frequency conversion; and
a filter control step of setting a filter coefficient used for the filtering, based on the sampling phase.

# FIG.1

FRE-
QUENCY
SETTING
INFOR-
MATION →

| SAMPLING-<br>PHASE<br>DETECTING<br>UNIT ⌐1 |

| FILTER-<br>COEFFICIENT<br>CONTROL<br>UNIT ⌐4 |

| SAMPLING-<br>CLOCK<br>DETECTING<br>UNIT ⌐2 |

| FILTER-<br>COEFFICIENT<br>STORING<br>UNIT ⌐5 |

· · ·

DIGITAL
SIGNAL →

| POLIPHASE<br>FILTER |

→ DIGITAL
SIGNAL
AFTER
SAMPLING
RATE
CONVER-
SION

⌐3

# FIG.2

FREQUENCY
SETTING
INFORMATION →

| X-bit COUNTER<br>(CUMULATIVE<br>ADDITION UNIT) ⌐11 |

→ SAMPLING PHASE
INFORMATION

↑

OPERATION
REFERENCE CLOCK

# FIG.3

PERIOD T

$2\pi$

21

0

PHASE $\theta$

20

$2^X$

X-bit
COUNTER
OUTPUT
VALUE

0

23

22

FRE-
QUENCY
SETTING
INFOR-
MATION

TIME t

PHASE RESOLUTION $= 1/2^X$

# FIG.4

DIGITAL
SIGNAL

31-0

INTERPOLATION
FILTER (FILTER
COEFFICIENT #0)

31-1

INTERPOLATION
FILTER (FILTER
COEFFICIENT #1)

32

33

↓ (Q/P)

DIGITAL
SIGNAL
AFTER
SAMPLING
RATE
CONVERSION

31-($2^X$-1)

INTERPOLATION
FILTER (FILTER
COEFFICIENT
#$2^X$-1)

# FIG.5

DIGITAL SIGNAL ⟶ INTERPOLATION FILTER (CAN SWITCH FILTER COEFFICIENT) ⟶ ↓ (Q/P) ⟶ DIGITAL SIGNAL AFTER SAMPLING RATE CONVERSION

⟋31 ⟋33

INTERPOLATION FILTER COEFFICIENT SETTING (#0~#2$^X$-1)

SAMPLING CLOCK

# FIG.6

FRE-QUENCY SETTING INFOR-MATION ⟶ SAMPLING-PHASE DETECTING UNIT ⟋1a

CLOCK ERROR INFOR-MATION ⟶

⟶ FILTER-COEFFICIENT CONTROL UNIT ⟋4

SAMPLING-CLOCK DETECTING UNIT ⟋2

FILTER-COEFFICIENT STORING UNIT ⟋5

DIGITAL SIGNAL ⟶ POLIPHASE FILTER ⟶ DIGITAL SIGNAL AFTER SAMPLING RATE CONVER-SION

⟋3

TIMING ADJUST-MENT CLOCK

11

# FIG.7

FREQUENCY SETTING INFORMATION → X-bit COUNTER (CUMULATIVE ADDITION UNIT) [11] → + [12] → SAMPLING PHASE INFORMATION

OPERATION REFERENCE CLOCK

CLOCK ERROR INFORMATION

# FIG.8

FREQUENCY SETTING INFORMATION → X-bit COUNTER (CUMULATIVE ADDITION UNIT) [11] → + [12] → SAMPLING PHASE INFORMATION

OPERATION REFERENCE CLOCK

CLOCK ERROR INFORMATION

## INTERNATIONAL SEARCH REPORT

| International application No. |
|---|
| PCT/JP2011/050964 |

| A. CLASSIFICATION OF SUBJECT MATTER |
|---|
| *H03H17/00*(2006.01)i, *H03H17/02*(2006.01)i |

According to International Patent Classification (IPC) or to both national classification and IPC

| B. FIELDS SEARCHED |
|---|

Minimum documentation searched (classification system followed by classification symbols)
H03H17/00-17/08

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| X<br>Y | JP 11-055077 A  (Commquest Technologies, Inc.),<br>26 February 1999 (26.02.1999),<br>entire text; all drawings<br>& US 6014682 A          & EP 881764 A2<br>& DE 69840313 D          & SG 68667 A<br>& TW 391110 B          & CN 1208298 A | 1-4,7,9,10<br>5,6,8 |
| Y | JP 11-191724 A  (Sharp Corp.),<br>13 July 1999 (13.07.1999),<br>entire text; all drawings<br>(Family: none) | 5,7-9 |
| Y | JP 03-283810 A  (Toshiba Corp.),<br>13 December 1991 (13.12.1991),<br>entire text; all drawings<br>(Family: none) | 6-9 |

☐ Further documents are listed in the continuation of Box C.          ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 25 February, 2011 (25.02.11) | 08 March, 2011 (08.03.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**EP 2 530 839 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **YOSHIKAZU NISHIMURA.** Communication System Design by Digital Signal Processing. CQ Publishing Co., Ltd, 85-89